# EUROPEAN PATENT SPECIFICATION

(11) **EP 1 233 442 B1**
(45) Date of publication and mention of the grant of the patent: **14.10.2009**
(21) Application number: 01306016.5
(22) Date of filing: 12.07.2001
(51) Int. Cl.: H01L 21/677

(54) **Non-contacting conveyance equipment**
Kontaktlose Transportvorrichtung
Dispositif de transport sans contact

(30) Priority: 20.02.2001 JP 2001044173
(43) Date of publication of application: 21.08.2002
(73) Proprietor: Harmotec Corporation, Nakakoma-gun, Yamanashi (JP)
(72) Inventor: Iwasaka, Hitoshi, Nakakoma-Gun, Yamanashi (JP); Tokunaga, Hideyuki, Nakakoma-Gun, Yamanashi (JP)
(74) Representative: Johnson, Terence Leslie

(56) References cited:
- EP-A- 0 807 964
- WO-A-97/45862
- US-A- 6 095 582
- US-B1- 6 168 697
- PATENT ABSTRACTS OF JAPAN vol. 1999, no. 14, 22 December 1999 (1999-12-22) -& JP 11 254369 A (SEIBU GIKEN CO LTD;DAIICHI SHISETSU KOGYO KK), 21 September 1999 (1999-09-21)

## Description

The invention relates to non-contacting conveyance equipment, particularly to such equipment as is used for handling delicate items during manufacture.

The invention relates to non-contacting conveyance equipment, particularly to such equipment which can hold a subject without contact, or relates to the non-contacting conveyance equipment used for rotation, or other handling during manufacture of delicate items such as silicon wafers.

In recent years the use of integrated circuit cards, smart cards, etc. has spread, and the product itself has also diversified.

While a wafer which serves for those materials in connection with such a product has also become thin, it has also tended to become extremely large.

Thus a wafer whose thickness is 0.5mm and with a diameter of 10 inches (25.4 cm) has been developed.

A thin and large wafer bends easily and is difficult to check and can crack.

Thus, checking is difficult, when conveying to a following process or moving a thin wafer within the same process in the manufacture stage of an IC.

That is, the mechanical integrity of a wafer falls as the diameter of a wafer increases, or during the formation of a thin object.

For this reason, non-contacting conveyance equipment is proposed. This non-contacting conveyance equipment is equipment which holds and conveys a wafer by un-contacting using air or nitrogen gas, and various kinds of things are already being put in practical use.

For example, in JP 11-254369, non-contact conveyance equipment is proposed.

With such non-contact conveyance equipment as disclosed in JP 11-254369 attracting and holding a conveyed object is proposed.

However, since a feeding mouth, manifold, and bell mouth for air are open for free passage, the structure is complicated and the manufacture cost of equipment is high.

Moreover, since it is a complicated structure, miniaturization is difficult, range of use of the equipment is limited so much, and there is small flexibility in use.

Furthermore, resistance to air flow which an air flow receives owing to the complicated structure is large.

Therefore, in order to save and maintenance power, a great volume of air needed to be used, energy efficiency decreases and energy saving is difficult.

Moreover, when a large volume of air is dealt with in a clean room, there is a problem with dust raising from a floor, or other surface.

It is an object of the invention to seek to mitigate these disadvantages.

Moreover, it can miniaturize easily and the action range can also be extended by it. Furthermore, it aims at offering the non-contacting conveyance equipment which can also realize energy curtailment.

Relevant prior art includes US 6168697 and SU537924.

According to the present invention there is provided a non-contacting conveyance equipment for conveying a semiconductor wafer comprising:
a base having at least two bodies, each body having an end face that in use opposes a semiconductor wafer to be conveyed, and at least one concave opening formed in the end face and surrounded by a cylindrical inner side wall;
each body having a fluid passageway having a pair of spouts to introduce fluid into an inner space of the concave opening along a circumference of the cylindrical inner side wall, said fluid in-use being introduced into said inner space in a horizontal direction to the end face so as to cause a swirl of fluid within the concave opening, wherein the pair of spouts are formed on the cylindrical inner side wall such that they face one another;
**characterised in that** it additionally comprises:
four centering guides; and
a centering mechanism comprising:
   a rotary actuator;
   a rotatable disk;
   for each centering guide, a link arm linking the centering guide to the rotatable disk; and
for each centering guide, an attachment piece radially protruding from the peripheral wall of the base and which has a slot, the centering guide passing through the slot and being guided by the slot so as to perform a radial movement with respect to the centre of the base in response to rotation of the rotatable disk by the rotary actuator.

Further preferred features are described in the dependent claims appended hereto.

Examples 1-7 do not form part of the present invention.

A form of implementation of this invention is explained by way of example in detail based on the following drawings, particularly Figures 5-7. Of the drawings:
Fig. 1 shows a perspective diagram showing the composition of a first exemplary non-contacting conveyance equipment;
   (a) is a figure from a slanting lower part;
   (b) is a perspective diagram from the slanting upper part;
Fig. 2 shows a sectional view of a non-contacting conveyance equipment, (a) is the I-I line sectional view of a figure 1 (a), and (b) is the II-II line sectional view of a figure 1 (a);
Fig. 3 shows a perspective diagram showing the composition of the non-contacting conveyance equipment in the 2nd example, (a) is a figure from a slanting lower part;
   (b) is a perspective diagram from the slanting upper part;
Fig. 4 shows the composition of the non-contacting conveyance equipment in the 2nd example, and (a) is an undersurface figure and (b) is the III-III line sectional view of a figure 4 (b);
Fig. 5 shows a front sectional view showing the composition of the non-contacting conveyance equipment of the present invention in the embodiment;
Fig. 6 shows a plane view showing the composition of the non-contacting conveyance equipment in the embodiment;
Fig. 7 shows the IV-IV line sectional view of a figure 5, it is the action diagram of a centering mechanism.
Fig. 8 shows a perspective diagram from the slanting upper part showing the composition of the non-contacting conveyance equipment in the 3rd example;
Fig. 9 shows the figure showing the composition of the non-contacting conveyance equipment in the 2nd example, and (a) is a plane view and (b) is the V-V line sectional view of a figure 9 (a);
Fig. 10 shows a perspective diagram showing the 4th non-contacting conveyance equipment in an example and its use situation.
Fig. 11 shows a plane view showing the composition of the non-contacting conveyance equipment in the 4th example and is the figure showing the state where it inserted in the wafer cassette.
Fig. 12 shows a horizontal sectional view of the non-contacting conveyance equipment in the 4th example.
Fig. 13 shows a perspective diagram showing the non-contacting conveyance equipment in the 5th example.
Fig. 14 shows a front sectional view showing partially the composition of the non-contacting conveyance equipment in the 6th example.
Fig. 15 shows a front sectional view showing partially the composition of the non-contacting conveyance equipment in the 7th example.

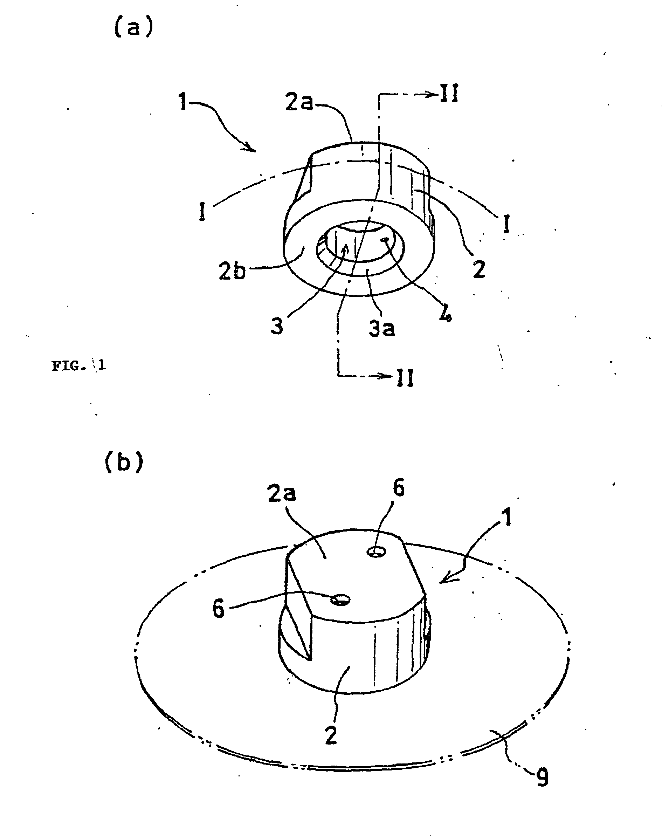

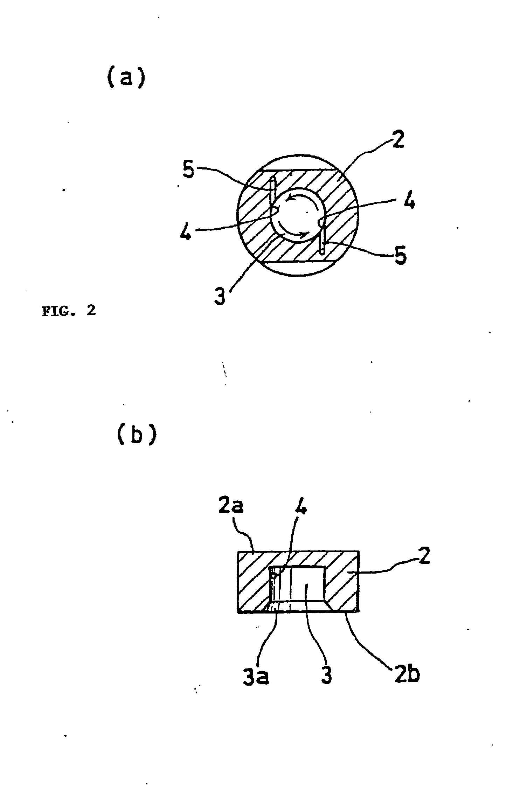

The 1st operation form is first explained using Fig. 1 and Fig. 2.

A view 1 is a perspective diagram showing the composition of the non-contacting conveyance equipment used in this invention, and (a) is a perspective diagram from a slanting lower part.
(b) is a perspective diagram from the slanting upper part. A view 2 is a sectional view of the non-contacting conveyance equipment used in this invention, (a) is the I-I line sectional view of a view 1 (a), and (b) is II-II line sectional view of a view 1 (a).
In these views, the non-contacting conveyance equipment 1 is equipment which holds and (chinning-exercises floatage) conveys a subject (here wafer 9) by un-contacting.
Moreover, this equipment is constituted using the pillar-shaped revolution flow formation means 2.

Namely, as for the non-contacting conveyance equipment 1, the inside is equipped with the circumference-like concave part 3.
It has the subject and flat-end-face 2b which counters formed in the opening side of the concave part 3.

And it has the fluid passage 5 which makes supply fluid breathe out along the direction of an inner circumference of the concave 3 into a concave 3 from the spout 4 which faces the inside of a concave 3.

From the fluid introduction mouth 6 prepared in closed-face 2a of the revolution flow formation means 2, the fluid passage 5 was perpendicularly drilled to closed-face 2a, was drilled still more horizontally, and has reached the jet nozzle 4 which faces the inside of a concave 3.

That is, the fluid passage 5 opens the fluid introduction mouth 6 and a spout 4 for free passage, and is making supply fluid breathe out along the direction of a circumference into a concave 3 from a spout 4.
By this supply fluid, a revolution style occurs in concave-part 3 inside.

The fluid introduction mouth 6, the fluid passage 5, and 2 sets of spouts 4 are formed.

The fluid (here air) which blows off from 2 sets of each of those spouts 4 is breathed out in the same direction along the direction of a circumference, and suits a revolution style mutually in slight strength.

Moreover, slope 3a is formed of camfering and the diameter of the opening edge of a concave part 3 is expanded in the shape of a trumpet.
Therefore, the revolution style generated in the concave part 3 can flow now out of a concave part 3 promptly by this slope 3a.

In the non-contacting conveyance equipment 1 of the above-mentioned composition, if air is supplied to the fluid introduction mouth 6 from the air supply equipment which is not illustrated here, the air will be blown into a concave 3 from a spout 4 through the fluid passage 5.

And it becomes a revolution style, and is rectified in the internal space of a concave part 3, and air flows out of a concave part 3 after that.

If the wafer 9 is arranged on the position which counters flat-end-face 2b of the revolution style formation object 2 at the time of the outflow, since air will serve as a high-speed style and will flow out along with flat-end-face 2b, it becomes negative pressure between flat-end-face 2b and a wafer 9.

Therefore, a wafer 9 is pushed by surrounding atmospheric pressure, and is attracted at the flat-end-face 2b side.

On the other hand, the air by which it is placed between the flat-end-face 2b and wafers 9 receives restitution, and a wafer 9 comes to be held by the balance by un-contacting, where flat-end-face 2b is countered.

Thus, in the 1st example, the wafer 9 was held with revolution style formation object 2 simple substance which forms a concave part 3, flat-face 2b, and the fluid passage 4.

Therefore, equipment can be made into the thing of easy composition, therefore the manufacture cost of equipment can be reduced sharply.

Moreover, since composition of equipment can be made easy, it becomes easy [ a miniaturization ].

Therefore, it can insert now also in the space which has not been used conventionally.

The action range as equipment can be extended by that cause, and conveyance movement in the narrow domain within the same process and processing equipment can also be performed now free.

Moreover, since it is rectified in accordance with an inside as it is and the air blown into the concave part 3 serves as a revolution style, it can make with a revolution style smoothly, without receiving most passage resistance.

Therefore, energy efficiency can be raised and energy curtailment can be realized.

Furthermore, make air blow off along the direction of a circumference in a concave part 3 - since it was made to generate a revolution style, the power of absorption by the negative pressure between flat-face 2b and a wafer 9 is markedly boiled as compared with the conventional thing, and becomes powerful.

In addition, although the fluid introduction mouth 6, the fluid passage 5, and 2 sets of spouts 4 were formed, only 1 set is good and you may make it prepare 3 or more sets in the above-mentioned explanation.

Moreover, although the fluid introduction mouth 6 was formed individually, this fluid introduction mouth 6 is made common, it branches off from there, and you may make it form the fluid passage 5 and a spout 4.

Furthermore, although the fluid passage 5 was formed in the combination of a perpendicular course and a level course, it is not limited to such a course.

What is necessary is just to form the fluid passage 5 so that air may be spouted along the direction of a circumference of a concave part 3 from the fluid introduction mouth 6.

Next, the 2nd example of the non-contacting conveyance equipment is explained using a view 3 and a view 4.

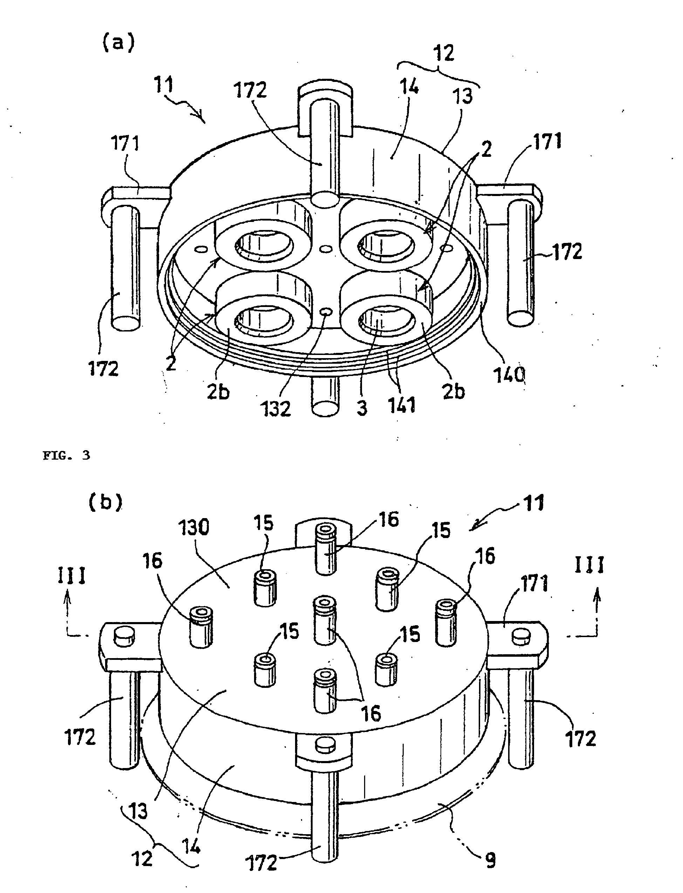

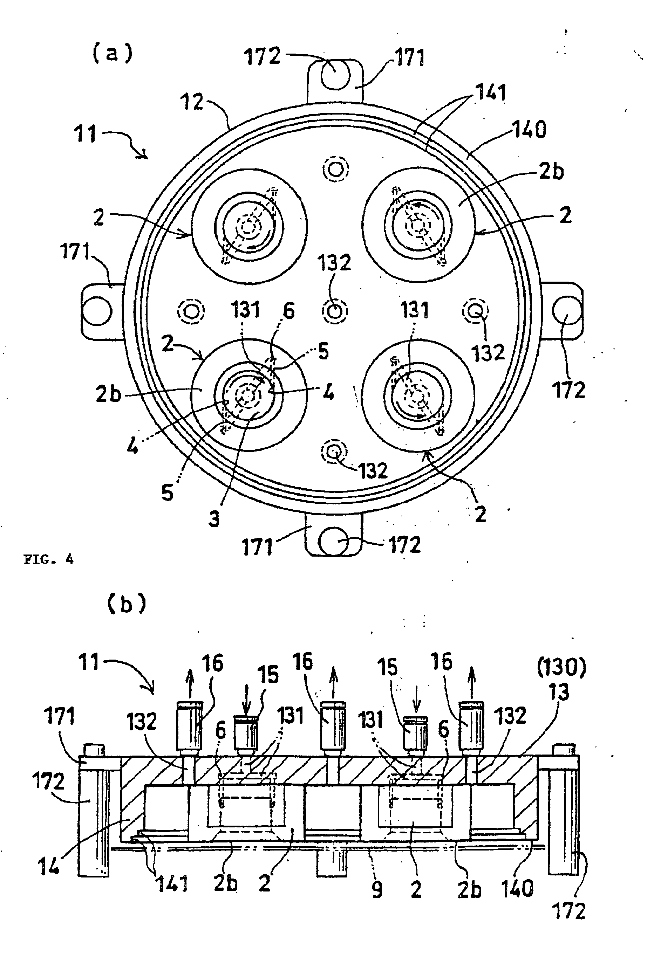

A figure 3 is a perspective diagram showing the composition of the non-contacting conveyance equipment in the 2nd example, and (a) is a figure from a slanting lower part.
(b) is a perspective diagram from the slanting upper part. A figure 4 is a figure showing the composition of the non-contacting conveyance equipment in the 2nd example, (a) is an undersurface figure and (b) is the III-III line sectional view of a figure 4 (b).

The composition element in the 1st example described above in this 2nd example, and abbreviation - the same mark is given to the same composition element, and the explanation is omitted

Two or more revolution flow formation means 2 by which it explained during explanation of the 1st embodiment are used for the non-contacting conveyance equipment 11 in this 2nd example.

That is, non-contacting conveyance equipment 11 is equipped with the support object 12 which consists of a peripheral surface 14 installed in the base 13 and the perimeter of the base 13, and four revolution style formation objects 2 attached in the base 13 of the support object 12.

Each of four revolution style formation objects 2 is attached in the inside (base field) of the base 13 by the closed-face 2a side.

Moreover, it is supported so that flat-end-face 2b may become the same side mutually.

The height of a peripheral surface 14 is adjusted so that the end face 140 may turn into the same field as each of this flat-end-face 2b.

Furthermore, the labyrinth fin 141 is formed in a part for the inner periphery of end face 140 of a peripheral surface 14 in the shape of [ two steps of ] stairs.

Corresponding to each of the revolution style formation object 2, the fluid supply mouth 15 is formed in the external surface 130 of the base 13.

The base secret communication way 131 to which each of this fluid supply mouth 15 and two fluid introduction mouths 6 and 6 of the corresponding revolution style formation object 2 is connected is branched and formed in the wall inside-of-the-body part of the base 13 from the fluid supply mouth 15 (view 4 (b)).

Five more fluid outlets 16 other than the four above-mentioned fluid supply mouths 15 are formed in the external surface 130 of the base 13.

The discharge passage 132 which leads to each of this fluid outlet 16 was installed through the wall inside-of-the-body part of the base 13, and the internal space and the fluid outlet 16 of the support object 12 are connected to it.

Furthermore, the piece 171 of attachment is protruded on four places at intervals of predetermined at the peripheral surface 14 of the support object 12.

The still more nearly cylindrical secession prevention guide 172 is installed in this piece 171 of attachment.

The end side of this secession prevention guide 172 has projected for a while to end face 140 of peripheral surface 14 or each flat-end-face 2b .

In the non-contacting conveyance equipment 11 of the above-mentioned composition, if the air from air supply equipment (illustration abbreviation) is sent to the fluid supply mouth 15, the air will be blown into a concave part 3 from a spout 4 through the base secret communication way 131, the fluid introduction mouth 6, and the fluid passage 5.

And it becomes a revolution flow, and is rectified in the internal space of a concave 3, and air flows out of a concave 3 after that.

When each of this revolution flow holds a wafer 9 by un-contacting, the direction is beforehand adjusted mutually so that a wafer 9 may not rotate.

For example, as shown in a figure 4 (a), the drive direction of the wafer 9 by two revolution flow formation means 2 turns into a clockwise rotation by arrangement of a spout 4.

The drive direction of the wafer of other two revolution flow formation means 2 turns into a counterclockwise rotation.

And like the case where it is the 1st above-mentioned operation form, if the wafer 9 is arranged on the position which counters flat-face 2b of the revolution style formation object 2 at the time of the outflow of each revolution style, a wafer 9 will come to be held by un-contacting in response to the power of absorption by negative pressure, and the restitution by the air style, where flat-face 2b is countered.

It moves a wafer 9 also being guided in the secession prevention guide 172 with the movement, if the support object 12 is moved in the state of the maintenance.

That is, non-contacting conveyance equipment 11 holds and conveys a wafer 9 by un-contacting.

An air style passing though flat-end-face 2b from concave part 3b goes into the internal space of the support object 12 as it is.

It passes along the discharge passage 132 and the fluid outlet 16 after that, and is compulsorily discharged with the exhaust (illustration abbreviation). Moreover, the flow is disturbed with the labyrinth fin 141, and the air style which reached the peripheral surface 14 receives resistance.

For this reason, the air which overcomes end face 140 of a peripheral surface 14 and flows out decreases.

Therefore, most air styles pile up in internal space, it passes along the discharge passage 132 and the fluid outlet 16, and is discharged compulsorily.

Moreover, the secession prevention guide 172 was formed further out of the peripheral surface 14.

For this reason, even if the wafer 9 held by un-contacting tends to move horizontally and it is going to deviate, the movement can be prevented and it can be made to stabilize and convey in the secession prevention guide 172.

It constituted from the 2nd example like the case of the 1 st above-mentioned example using the revolution flow formation means 2 of easy composition.

For this reason, reduction, a miniaturization, and energy saving of cost were realizable.

Moreover, since it was made to make a wafer 9 attract by the revolution flow formed in the concave 3, the power of absorption can be boiled markedly and can be made powerful

Moreover, since it was made to generate this revolution style in four places, a wafer 9 came to be attracted over the whole further much more powerfully.

Therefore, it becomes possible to correct the curvature over the whole, though curvature is in a wafer 9, and the reform power also becomes powerful.

Consequently, a wafer 9 is large, and even if it is the case where it has moreover curved, the wafer can be certainly held by un-contacting, and where conveyance is also stabilized, it can -carry out certainly.

Moreover, each revolution flow formation means 2 has simple composition which blows air into a concave 3 and forms a revolution flow directly.

For this reason, it became the stable revolution style and the maintenance power in which it does not contact is also stable.

Therefore, four revolution flow formation means 2 become uniform at each other.

Non-contacting maintenance of the wafer 9 which tended to become thereby former a little unstable can be performed with sufficient balance.

Furthermore, since the maintenance power in which this it does not contact is powerful, even if it reverses the whole non-contacting conveyance equipment 11, a maintenance state is maintainable as it is.

Moreover, a wafer 9 can be reversed and it can also convey to the following distance.

In addition, although considered as the composition which establishes four revolution style formation objects 2 in the above-mentioned explanation, you may be the composition of it not being necessary to limit to four pieces, and preparing the two or more arbitrary numbers.

Moreover, although the labyrinth fin 141 of a peripheral surface 14 was made into the shape of stairs, what is necessary is just the structure which increases air resistance.

For example, it is good also as slot form.

Furthermore, the fluid supply mouth 15 and the fluid outlet 16 may prepare the arbitrary numbers.

What is necessary is, just to make it prepare in at least three places also about the secession prevention guide 172.

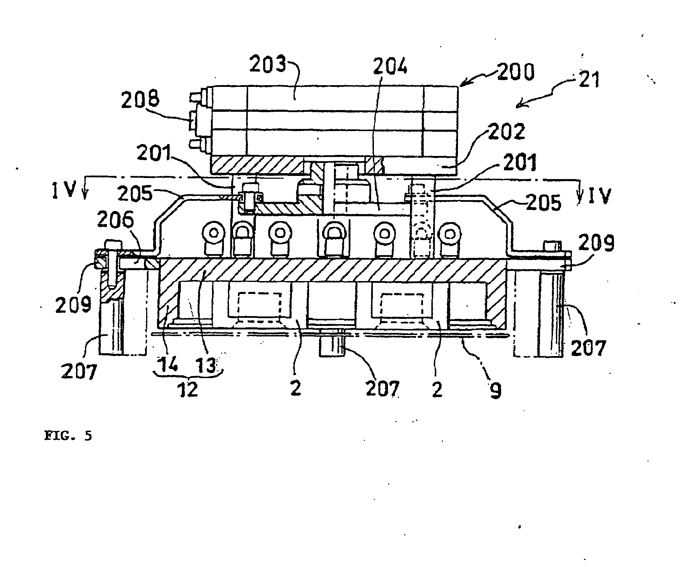

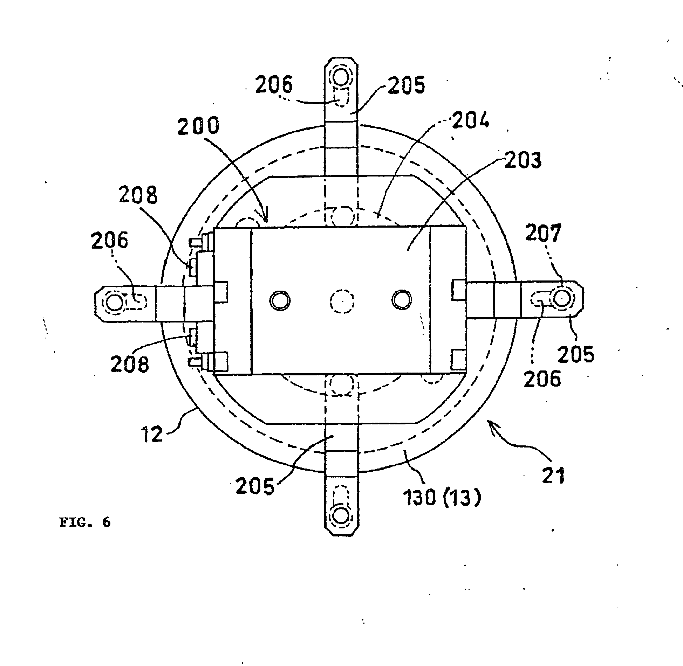

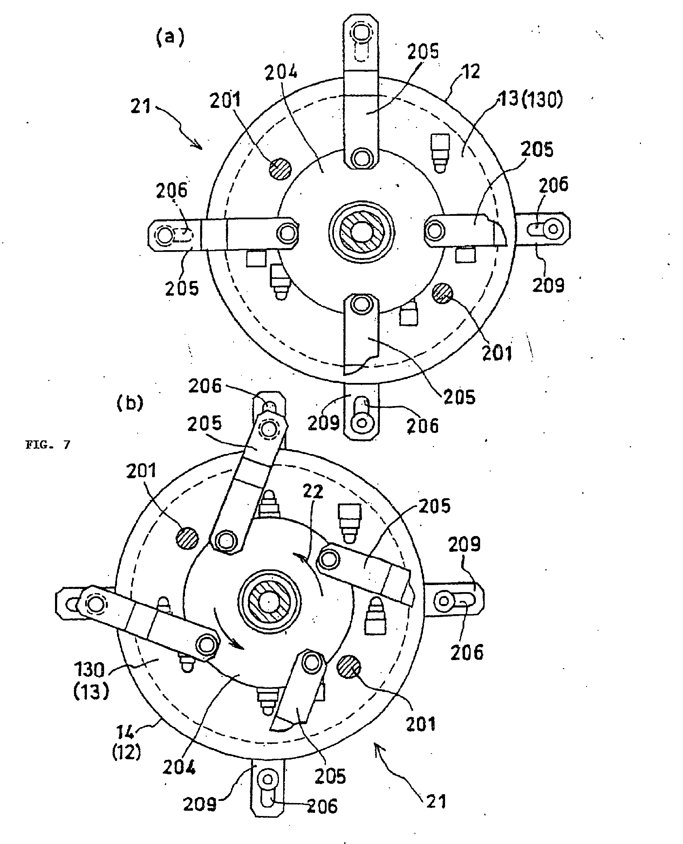

Next, the 3rd embodiment of the non-contacting conveyance equipment of this invention is explained using a figure 5, a figure 6, and a figure 7.

A figure 5 is a front sectional view showing the composition of the non-contacting conveyance equipment in the 3rd embodiment.

A view 6 is the plane view.

A view 7 is IV-IV line sectional view of a view 5, and is an action diagram of a centering mechanism.

The composition element in the 2nd example described above in the embodiment of the invention, and abbreviation -- the same mark is given to the same composition element, and the explanation is omitted

The point that the non-contacting conveyance equipment 21 of this embodiment is different from the above-mentioned non-contacting conveyance equipment 11 of the 2nd example is a point of having formed the centering mechanism 200 in the object for positioning and the object for secession prevention of a wafer 9 which were held by un-contacting.

This centering mechanism 200 is equipped with the rotary actuator 203 fixed on the base board 202 supported with the support 201 set up on the external surface 130 of the base 13.

Moreover, the centering mechanism 200 is equipped with the link arm 205 prepared in the perimeter edge of the flange 204 attached in the shaft (illustration abbreviation) of the rotary actuator 203 towards the four quarters.

Each of this link arm 205 consists of crooked long and slender board material, the end is installed in the perimeter edge of a flange 204, and other one end is level.

Moreover, the slot 206 for a guide is established in the piece 209 of attachment which protruded in the direction of a path from external surface 130.

And the bolt was inserted in the slot 206 for a guide of the hole of a bolt, and the piece 209 of attachment established in other one end of this link arm 205.

The centering guide (arm for centering) 207 can be screwed on and installed in the bolt, and the centering guide 207 can be slid along the slot 206 for a guide.

Under composition of having described above, the centering mechanism 200 of non-contacting conveyance equipment 21 operates as follows.

First, if air is sent into the drive air insertion mouth 208 of the rotary actuator 203, the rotary actuator 203 will operate.

According to the operation, a flange 204 rotates only a predetermined angle in the direction shown by the arrow 22 from the state of a view 7 (a) to the state of a view 7 (b), and also moves each link arm 205 to it according to the rotation.

At this time, the centering guide 207 currently installed by other one end of the link arm 205 is guided in the slot 206 for a guide of the piece 209 of attachment, and performs going-straight movement.

And only predetermined distance moves in the direction of a center of the base 13, and each stops.

As for the wafer 9 currently held by un-contacting by non-contacting conveyance equipment 21, the perimeter is regulated from the four quarters by movement of the direction of a center of this centering guide 207.

Therefore, the center of a wafer 9 comes to be in agreement with the center of the internal space of the support object 12, and a wafer 9 is positioned.

On the other hand, when cancelling the regulation on a wafer 9, an opposite direction is made to rotate a flange 204 in an arrow 22 by the rotary actuator 203.

Thereby, the centering guide 207 moves in the direction which separates from a center of the base 13, and a wafer 9 is free.

Thus, according to the operation to the rotary actuator 203, the centering guide 207 isolates or approaches only the same distance to a peripheral surface 14, respectively.

And while storing the wafer 9 currently held by un-contacting in the inner side, the positioning is performed with high precision.

Therefore, when conveying a wafer 9 and arranging in a predetermined position, it is highly precise and can arrange.

Therefore, the following process can also do work with sufficient accuracy smoothly.

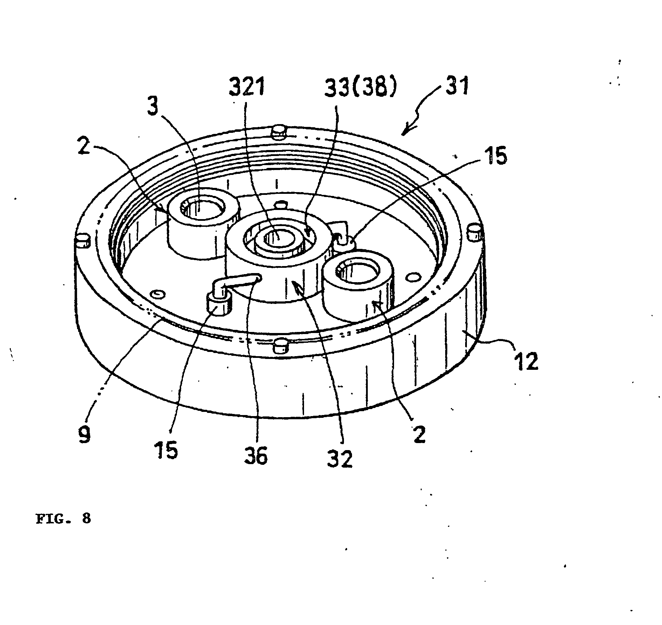

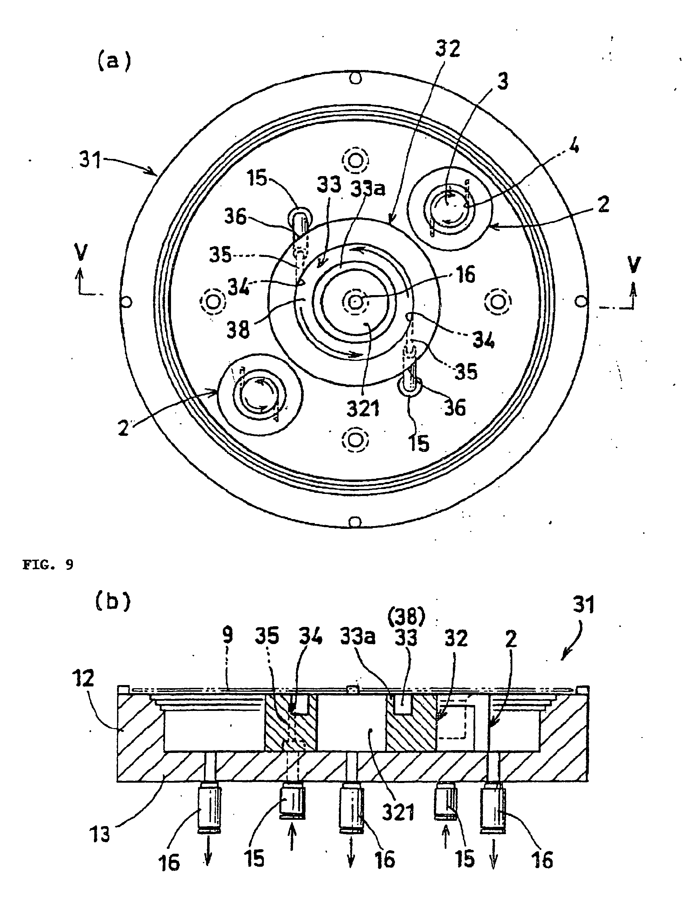

Next, a third example of the non-contacting conveyance equipment is explained using a figure 8 and a figure 9.

A figure 8 is a perspective diagram from the slanting upper part showing the composition of the non-contacting conveyance equipment in the 3rd example.

A figure 9 is a figure showing the composition of the non-contacting conveyance equipment in the 3rd example, (a) is a plane view and (b) is the V-V line sectional view of a figure 9 (a).

In this 3rd example, the same mark is given to the same composition element as the composition element in the 2nd above-mentioned example, and the explanation is omitted.

With the non-contacting conveyance equipment 31 of this 3rd example, the revolution flow formation means 32 allotted to a center and the revolution flow formation means 2 allotted to the circumference are considered as different composition.

Two revolution flow formation means 2 arranged around have the same composition as what was used by the 1st example, 2nd example and the embodiment [above mentioned].

However, the revolution flow formation means 32 arranged at the center has the following composition.

That is, peripheral-wall 33a is prepared in the inside of a concave 33, and the revolution flow passage 38 is formed in this revolution flow formation means 32.

And a hole 321 is formed in the center.

Moreover, the fluid introduction mouth 36 is formed so that the perimeter side of the revolution flow formation means 32 may be faced.

The fluid passage 35 was horizontally drilled in a part for the inside of thick of the revolution flow formation means 32 from this fluid introduction mouth 36, and has reached the spout 34 formed so that the revolution flow passage 38 might be attended.

Air is breathed out along the direction of a circumference in the revolution flow passage 38 from this spout 34, and it serves as a revolution flow, showing around at the revolution flow passage 38.

The fluid introduction mouth 36, the fluid passage 35, and 2 sets of spouts 34 are formed.

The air which blows off from 2 sets of each of those spouts 34 is breathed out in the same direction along the direction of a circumference, and suits a revolution flow mutually in slight strength.

Moreover, as shown in a figure 9 (b), the fluid supply mouth 15 prepared in the base 13 makes two fluid introduction mouths 36 of the revolution flow formation means 32 allotted to the center correspond, and is prepared.

Moreover, one piece is prepared at a time in each of the revolution flow formation means 2 allotted to the circumference like the case of the 2nd embodiment.

And each of the revolution flow formation means 2 allotted to the circumference is constituted so that the rotation direction of a revolution flow may become reverse mutually.

At this 4th embodiment, a wafer 9 is held by un-contacting by the revolution flow generated with the revolution flow formation means 32 and 2.

And while doing so the same effect as the case of each above-mentioned embodiment, the following peculiar action effects are demonstrated.

That is, since the revolution flow passage 38 was established in the revolution flow formation means 32 allotted to the center, the air which flows this revolution flow passage 38 serves as a high-speed revolution flow rectification-ized more.

Therefore, the torque which is going to rotate the wafer 9 currently held by un-contacting is strengthened more.

Therefore, a wafer 9 comes to rotate at high speed to the extent that it was not able to attain at the conventional revolution flow.

The equipment which carries out centrifugal separation and dries the moisture which adhered to the wafer 9 at the washing process can be constituted using high-speed rotation of the wafer 9 by this revolution flow formation means 32.

Moreover, it can constitute also as a washing machine which bounds off and washes the foreign substance adhering to the wafer 9, without attaching a crack in any way by un-contacting.

Moreover, the rotation drive when detecting the orientation flat and V notch of a wafer, the rotation drive at the time of appearance inspection of a wafer, the rotation drive at the time of wafer etching, etc. can use it, being various.

And the revolution flow formation means 2 has been arranged on both the sides of the revolution flow formation means 32.

The direction and intensity of a revolution flow in the revolution flow formation means 2 of both the side are controlled by the amount of supply air.

Thereby, high-speed rotation of the wafer 9 by the central revolution flow formation means 32 is controllable at a proper rotation speed.

Therefore, it can be appropriately used now as a drier or a washing machine.

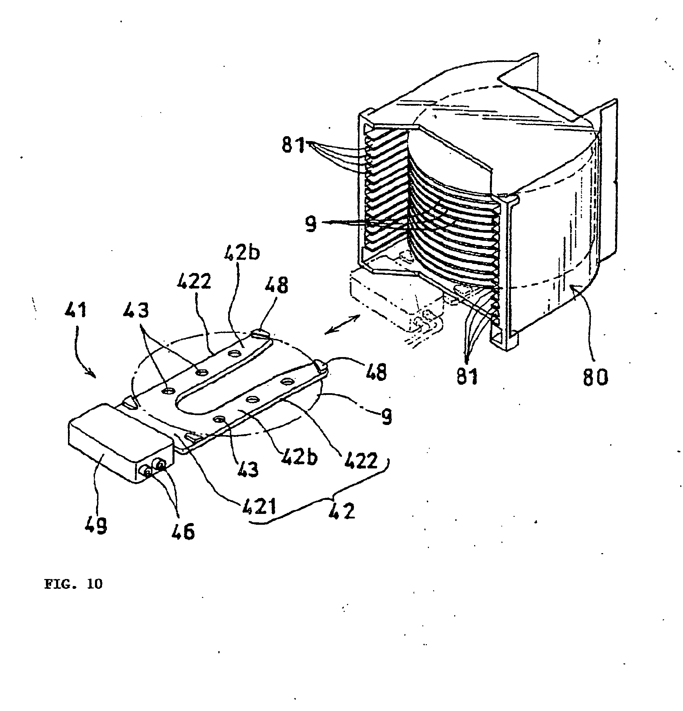

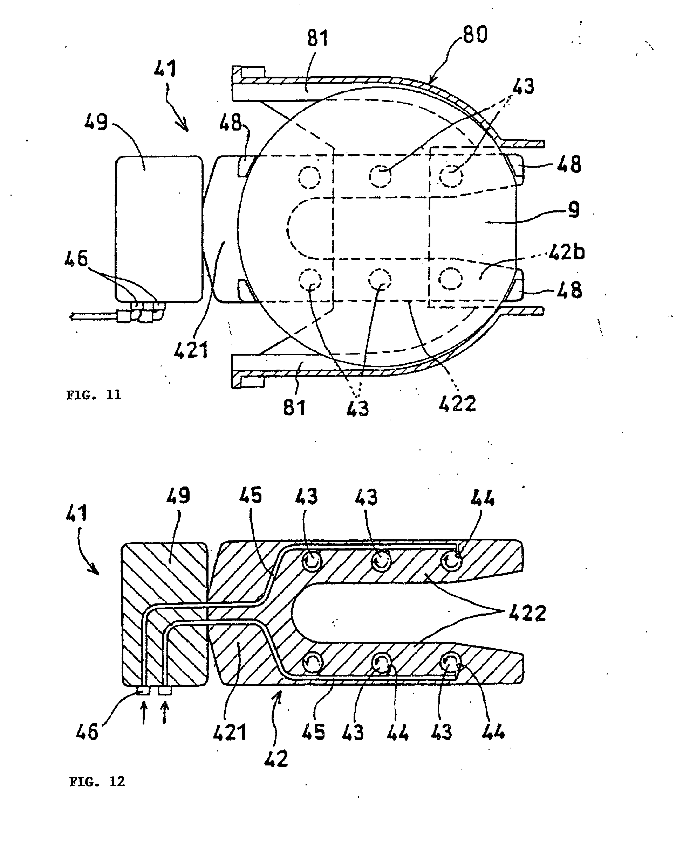

Next, the 5th embodiment of the non-contacting conveyance equipment of this invention is explained using a figure 10, a figure 11, and a figure 12.

A figure 10 is a perspective diagram showing the 4th non-contacting conveyance equipment in an example and its use situation.

A figure 11 is a figure showing the state where are the plane view showing the composition of the non-contacting conveyance equipment in the 4th example, and it inserted in the wafer cassette.

A figure 12 is a horizontal sectional view of the non-contacting conveyance equipment in the 4th example.

An inside is with the circumference-like concave 43 to the board-like base (revolution flow formation means) 42 which has flat side 42b to which non-contacting conveyance equipment 41 counters a wafer 9 in these figures.

The fluid passage 45 which makes air breathe out along the direction of an inner circumference is formed into a concave 43, and it consists of spouts 44 which face the inside of the concave 43.

The base 42 consists of the base 421 and two arm parts 422 which branch from the base 421 to two forks.

The grasping part 49 for enabling movement of this base 42 adheres to the end side of the base 421.

It has located the concave 43 in a line with each of the arm part 422 three pieces at a time every [ some ] and here.

Moreover, the 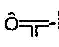 -like secession prevention guide 48 is formed in one end besides each ijròö 422.

As shown in a figure 12, the fluid passage 45 becomes two series from two fluid introduction mouths 46 which carry out a opening to the side of the grasping part 49, and is installed to two arm parts 422.

The fluid passage 45 of each series has branched to the spout 44 which attends a concave 43.

In the non-contacting conveyance equipment 41 of the above-mentioned composition, if the air from air supply equipment (illustration abbreviation) is sent to the fluid introduction mouth 46, the air will be blown into each concave 43 from a spout 44 through the fluid passage 45.

And it becomes a revolution flow, and is rectified in the internal space of a concave 43, and the air flows out of a concave 43 after that.

When each of this revolution flow holds a wafer 9 by un-contacting, the direction is beforehand adjusted mutually so that a wafer 9 may not rotate.

For example, clockwise, as shown in a figure 12, it is adjusted by three concaves 43 of one arm part 422 by changing the arrangement position of a spout 44 at three concaves 43 of the arm part 422 of another side so that it may become a counterclockwise rotation.

And like the case where it is each above-mentioned embodiment when the wafer 9 is arranged on the position which counters flat side 42b of a base 42 at the time of the outflow of each revolution flow, a wafer 9 comes to be held by the balance of the negative pressure by the outflow of a revolution flow, and the restitution by the air flow by un-contacting, where flat side 42b is countered.

If the grasping part 49 is held in the state of the maintenance and a base 42 is moved, it will move with the movement, a wafer 9 being guided in the secession prevention guide 48.

That is, non-contacting conveyance equipment 41 holds and conveys a wafer 9 by un-contacting.

Since the base 42 of this non-contacting conveyance equipment 41 is thinly constituted in the shape of a board, as shown in a figure 10 and a figure 11, insertion to the wafer 9 which adjoins each other by the upper and lower sides, and the narrow opening between nine is attained also to the wafer 9 currently stacked 81 steps of each shelf of the wafer cassette 80.

Thus, in the 4th example of this invention, since it was made to make a wafer 9 attract by the revolution flow formed in each concave 43 like the case of each above-mentioned example, even when the power of absorption can be made powerful and a base 42 is made into the shape of a board, the power of holding a wafer can fully be secured.

Therefore, non-contacting conveyance equipment 41 can be constituted now in the shape of a board, access of accessing, since it is stacked conventionally is attained free also to the wafer of which the stage to the wafer 9 in the difficult wafer cassette 80, and the wafer 9 from the wafer cassette 80 can be conveyed now more smoothly and free.

Moreover, in case the wafer cassette 80 is contained and loaded with a wafer, it can carry in to a desired position free.

That is, taking out from the wafer cassette 80 and carrying in to the wafer cassette 80 can be performed free, and working efficiency can also be raised sharply.

Furthermore, since the revolution flow is also formed by two or more places, even if the maintenance power in which this it does not contact is powerful, and it is the wafer 9 which has curvature, non-contacting maintenance in the state where the curvature was corrected is attained.

Moreover, even if it reverses the whole non-contacting conveyance equipment 41, a maintenance state can be maintained as it is, a wafer 9 is reversed, and the wafer cassette 80 can also be loaded, and it can be made reversed, and can also convey to the following distance.

In addition, although the board-like base 42 was made into two forks and considered as it, besides the composition which puts three concaves 43 in order at a time in the above-mentioned explanation, the mode is arbitrary, is good and should just give the composition for which it was suitable according to the use.

For example, it may consider as one arm instead of two forks, and you may constitute so that only one concave may be prepared in the arm.

Moreover, what is necessary is just to also form this grasping part 49 if needed, although the grasping part 49 was formed.

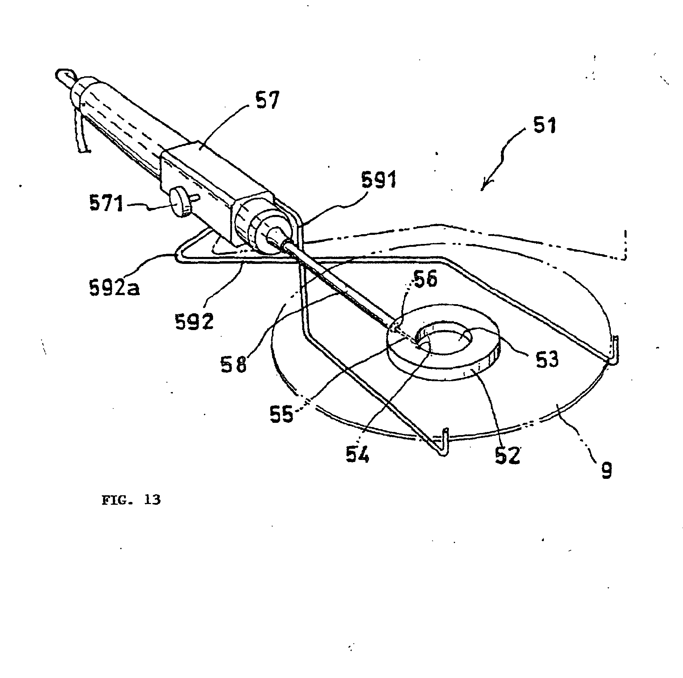

Next, a 5th example of the non-contacting conveyance equipment is explained using a figure 13.

A figure 13 is a perspective diagram showing the non-contacting conveyance equipment in the 5th example.

Non-contacting conveyance equipment 51 is equipped with the fluid piping 58 by which an inside penetrates a revolution flow formation means 52 to have the circumference-like concave 53, the long and slender pillar-shaped grasping part 57, and the inside of this grasping part 57, and the revolution flow formation means 52 is being fixed to the end in the figure.

The fluid introduction mouth 56 which carries out a opening to the perimeter side, the spout 54 faced at a concave 53, and this fluid introduction mouth 56 and spout 54 are prepared in the free passage é©éÚ fluid passage 55 by the revolution flow formation means 52.

The fluid piping 58 is connected to this fluid introduction mouth 56, and the air supplied from the fluid piping 58 is breathed out along the direction of a circumference through the fluid introduction mouth 56 and the fluid passage 55 in a concave 53 from a spout 54, and serves as a revolution flow inside a concave 53.

From the grasping part 57, two bent guide arms 591,592 extend through the both sides of a concave 53, and are bent still more perpendicularly by each tip side.

If push in, it has partial 592a, one guide arm 592 moves in the direction which will separate from the guide arm 591 to which another side is being fixed according to the operation if this pushing partial 592a is pushed in by the hand grasping the grasping part 57 bent and formed in about 57 grasping part and pushing operation is cancelled, it will return to the original position.

Moreover, the opening-and-closing switch 571 which opens and closes the passage of the fluid piping 58 is formed in the grasping part 57.

A wafer 9 can be held, even if the number of the revolution flow formation means 52 is one, since it will become powerful [ the power of absorption ], although the non-contacting conveyance equipment 51 of the above-mentioned composition holds a wafer 9 by un-contacting like the case of each above-mentioned embodiment using the outflow of the revolution flow formed in the concave 53.

Therefore, by fixing the one revolution flow formation means 52 to the end of the fluid piping 58, holding the grasping part 57, and operating it by hand, a wafer 9 is held free like tweezers and it can convey now to a desired position.

When it is going to catch a wafer 9, pushing partial 592a is pushed in, the guide arm 592 is moved to the position of two dotted lines of a figure 13, a wafer 9 is made easy to catch, a concave 53 is brought close to a wafer 9 in the state, and maintenance by un-contacting is made to perform in that case, since the guide arm 591,592 was formed.

Then, it can push in at the time of conveyance, pushing of partial 592a can be cancelled, the guide arm 592 can be returned to the original position, and a wafer 9 can be conveyed with the posture prevented and stabilized [ that a wafer 9 breaks away in the perpendicular bending portion formed in the two end side of the guide arm 591,592 and ].

Thus, like tweezers, the non-contacting conveyance equipment 51 in this 5th embodiment is caught free, and can convey a wafer 9 now.

In addition, although air was used as fluid, you may make it use the gas or the liquids other than air in each above-mentioned embodiment.

Moreover, although it was explained that the subject held by un-contacting was a wafer, it is good also considering the arbitrary things of not only a wafer but parts and others as a subject.

Moreover, you may make it form, for example in the shape of a polygon, although each concaves 3, 33, 43, and 53 were explained as a circumference-like thing, without limiting in the shape of the circumference.

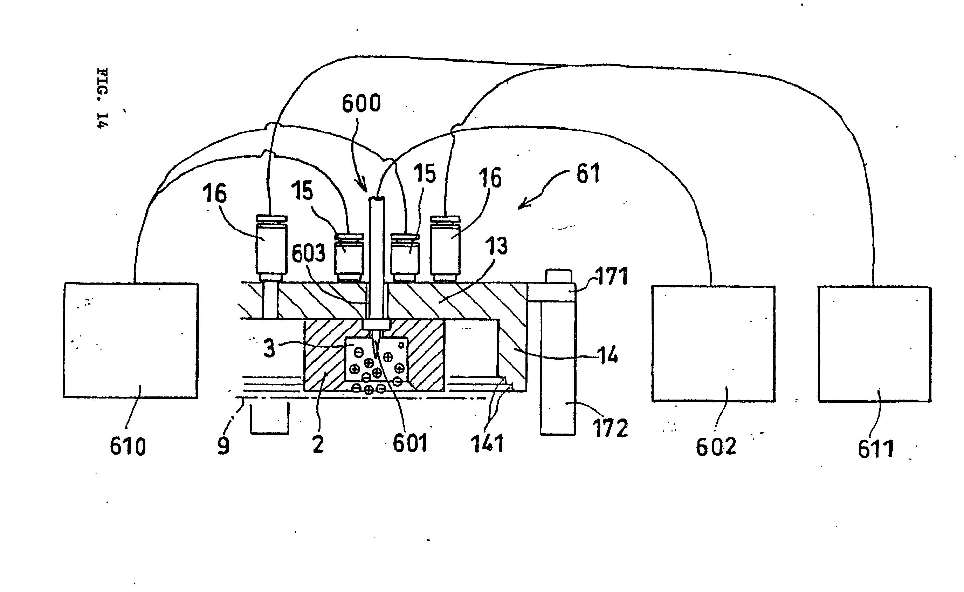

Next, a 6th example of the non-contacting conveyance equipment is explained using a figure 14.

A figure 14 is a front sectional view showing partially the composition of the non-contacting conveyance equipment in the 6th example.

The composition element in the 2nd example described above in this 6th example, and abbreviation -- the same mark is given to the same composition element, and the explanation is omitted

The points that the non-contacting conveyance equipment 61 of this 6th example is different from the above-mentioned non-contacting conveyance equipment 11 of the 2nd example are the following points.

The point which was open for free passage in the source 610 of ultrasonic air which generates the air which forms two fluid supply mouths 15 in each of the revolution flow formation means 2, and has vibration of ultrasonic frequency for the each.

Moreover, it is the point established so that the inside of the concave 3 of the revolution flow formation means 2 might newly be faced the ion generation source 600.

This ion generation source 600 has the electric pole 601 and the high-voltage power supply 602 which impresses the high voltage to this electric pole 601, as shown in a figure 14.

This electric pole 601 is formed so that the tip may face the internal space of the concave 3 of the revolution flow formation means 2 from the hole 603 prepared in the base 13.

And by making the high voltage impress, ion is generated around a needle tip portion.

Moreover, from the fluid supply mouth 15, the ultrasonic air supplied from the source 610 of ultrasonic air is supplied as supply fluid.

This electric-pole needle 601 generates plus ion or an anion according to the polarity of the voltage to impress.

The ion is carried to the ultrasonic air supplied from the fluid supply mouth 15, and passes through the surface of the wafer 9 held by un-contacting.

And the ion is attracted by the fluid outlet 16 which is open for free passage in the source 611 of a vacuum, and is discharged outside through the source 611 of a vacuum.

Usually, the removal will become difficult, once dust (particle) tends to adhere to the wafer surface and it adheres, when the wafer 9 is charged.

In this 6th embodiment, as mentioned above, since ion is blown and is contacted on the surface of this wafer 9, the electrification is neutralized and adhesion of the particle by static electricity can weaken a wafer 9.

Therefore, the supply fluid from the fluid supply mouth 15 can remove easily the particle which this adhesion was able to weaken, and can make the surface of a wafer 9 clean.

The removed particle is discharged from the fluid outlet 16 with supply fluid.

And the supply fluid is made into ultrasonic air in this 6th example.

The oscillating air of this ultrasonic wave has the action which the air layer near the wafer surface is vibrated and exfoliates par âeâBâNâï from the surface.

Therefore, the action effect of particle removal is strengthened further and can remove a particle more certainly.

Moreover, since a wafer 9 is neutralized with ion, particle adhesion to the wafer 9 by subsequent electrification can be prevented certainly.

In addition, in this embodiment, although the ion source of supply 600 and the source 610 of ultrasonic air were used together, you may constitute so that only the either may be used, and the effect of particle removal can be demonstrated also by that case.

For example, without preparing an ion source of supply in a fluid supply mouth, the source of ultrasonic air is made to open for free passage and it is good also considering supply fluid as ultrasonic air.

Moreover, only an ion source of supply is prepared in a fluid supply mouth, and it is good also considering supply fluid as not ultrasonic air but usual fluid.

The effect of particle removal can be demonstrated by any [ the ] case.

And originally the non-contacting conveyance equipment 61 of this 6th example is equipment which holds and conveys a subject by un-contacting.

However, it can serve now also both as the static electricity removal equipment which neutralizes static electricity, and the clean equipment which performs particle removal further by preparing an ion source of supply like this embodiment.

Moreover, it can serve as the clean equipment which performs par âeâBâNâï removal only by using ultrasonic air for the supply fluid of this non-contacting conveyance equipment.

Furthermore, by making the supply fluid into ultrasonic air, while preparing an ion source of supply in this equipment, this equipment can serve now as the both sides of static electricity removal equipment and clean equipment, and can realize various functions non-contacting conveyance equipment.

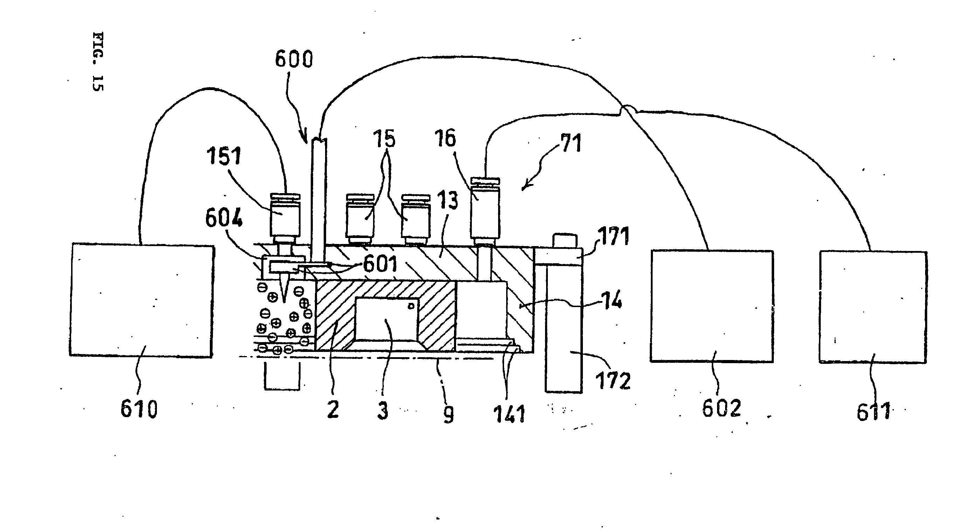

A figure 15 is a front sectional view showing partially the composition of the non-contacting conveyance equipment in the 7th example.

In this 7th example, the same mark is given to the same composition element as the composition element in the 6th above-mentioned example, and the explanation is omitted.

The point that the non-contacting conveyance equipment 71 of this 8th embodiment is different from the above-mentioned non-contacting conveyance equipment 61 of the 6th example is a point which did not form the electric pole 601 of the source 600 of ultrasonic air in the revolution flow formation means 2, but was established so that the wafer 9 currently held by un-contacting might be attended.

That is, an electric pole 601 is formed in the base 13 other than revolution flow formation means 2, and the wafer 9 currently held by un-contacting is made to overlook the tip of an electric pole 601.

Moreover, the fluid supply mouth 151 which leads to the source 610 of ultrasonic air has attended this hole 604.

Thus, since the ion generated from the electric pole 601 with constituting contacts the surface of a wafer 9, it demonstrates the same action effect as the case of the 6th above-mentioned example.

In addition, although the fluid supply mouth 151 which supplies ultrasonic air in this case in addition to two fluid supply mouth 15 of the whirlpool formation object 2 is formed, the flux of this ultrasonic air is enough if ion is the flux of the grade which arrives at the surface of a wafer 9.

And non-contacting maintenance of the wafer 9 by the fluid supplied to the whirlpool formation object 2 is not affected at all.

Moreover, the particle removed by this ion and ultrasonic air is promptly discharged from the fluid outlet 16 prepared in two or more places of the base 13.

In addition, although it constituted from the above 6th and the 7th example so that the ultrasonic air from the source 610 of ultrasonic air might be ionized by the electric pole 601

Air may be first ionized by the electric pole, and you may constitute so that the source of ultrasonic air may be used for the ionized air and ultrasonic vibration may be given.

That is, if the ion in ultrasonic air is given and finally contacts the subject held by un-contacting, either of the composition is employable.

As mentioned above, although this invention was explained based on the form of operation of a drawing, this invention is not limited to each above-mentioned embodiment, and unless the composition of a publication is changed into a claim, it can be carried out even to how.

### Description of Notations

1 non-contacting conveyance equipment
2 revolution flow formation means
2a closed face
2b flat edge surface
3 concaves
4 Spout
5 fluid passages
6 fluid introduction mouth
9 Wafer
11 non-contacting conveyance equipment
12 support objects
13 base
130 external surface
131 base secret communication way
132 discharge passages
14 peripheral walls
140 The edge surface of peripheral walls
141 labyrinths
15 fluid supply mouth
16 fluid outlet
21 non-contacting conveyance equipment
31 non-contacting conveyance equipment
32 revolution flow formation means
33 concaves
34 spouts
35 fluid passages
36 fluid introduction mouth
38 revolution flow passage
41 non-contacting conveyance equipment
42 revolution flow formation means
42b flat side
43 concaves
44 spouts
45 fluid passages
46 fluid introduction mouth
49 grasping parts
51 non-contacting conveyance equipment
52 revolution flow formation means
53 concaves
54 spouts
55 fluid passages
56 fluid introduction mouth
57 grasping parts
58 fluid piping
80 wafer cassettes
81 shelves
   The fluid supply mouth for 151 ultrasonic-wave air
   The piece of 171 attachment
172 secession prevention guide
200 centering mechanisms
201 supports
202 base board
203 rotary actuator
204 flanges
205 link arm
   The slot for 206 guides
207 centering guide
208 drive air insertion mouth
321 through holes
   The 421 base
422 arms
571 opening-and-closing switch
591 guide arm
592 guide arm
592a pushing portion
61 non-contacting conveyance equipment
600 ion generation sources
601 electric poles
602 high-voltage power supplies
   It is a hole 603,604,copies.
   The source of 610 ultrasonic wave air
   The source of 611 vacuums

## Claims

1. A non-contacting conveyance equipment (21) for conveying a semiconductor wafer comprising:
a base (13) having at least two bodies (2), each body (2) having an end face (2b) that in use opposes a semiconductor wafer (9) to be conveyed, and at least one concave opening (3) formed in the end face (2b) and surrounded by a cylindrical inner side wall;
each body (2) having a fluid passageway (5) having a pair of spouts (4) to introduce fluid into an inner space of the concave opening (3) along a circumference of the cylindrical inner side wall, said fluid in-use being introduced into said inner space in a horizontal direction to the end face so as to cause a swirl of fluid within the concave opening (3), wherein the pair of spouts (4) are formed on the cylindrical inner side wall such that they face one another;
**characterised in that** it additionally comprises:
four centering guides (207); and
a centering mechanism (200) comprising:
a rotary actuator (203);
a rotatable flange (204);
for each centering guide (207), a link arm (205) linking the centering guide (207) to the rotatable flange (204); and
for each centering guide (207), an attachment piece (209) radially protruding from the peripheral surface (14) of the base (13) and which has a slot (206), the centering guide (207) passing through the slot (206) and being guided by the slot (206) so as to perform a radial movement with respect to the centre of the base (13) in response to rotation of the rotatable flange (204) by the rotary actuator (203).

2. A non-contacting conveyance equipment (21) according to claim 1, wherein the centering mechanism (200) is pneumatically driven.

3. A non-contacting conveyance equipment (21) according to claim 1, wherein the end face (2b) comprises a chamfered edge (3a).

## Patentansprüche

1. Kontaktlose Transportvorrichtung (21) für das Transportieren eines Halbleiterwafers, die aufweist:
eine Basis (13) mit mindestens zwei Körpern (2), wobei jeder Körper (2) eine Stirnfläche (2b), die bei Benutzung einem zu transportierenden Halbleiterwafer (9) gegenüberliegt, und mindestens eine konkave Öffnung (3) aufweist, die in der Stirnfläche (2b) gebildet und durch eine zylindrische innere Seitenwand umgeben wird;
wobei jeder Körper (2) einen Fluiddurchgang (5) mit einem Paar Einläufen (4) aufweist, um Fluid in einen Innenraum der konkaven Öffnung (3) längs eines Umfanges der zylindrischen inneren Seitenwand einzuführen, wobei das Fluid beim Gebrauch in den Innenraum in einer horizontalen Richtung zur Stirnfläche eingeführt wird, um so einen Wirbel des Fluids innerhalb der konkaven Öffnung (3) hervorzurufen, wobei das Paar Einläufe (4) auf der zylindrischen inneren Seitenwand so ausgebildet ist, dass sie zueinander hin liegen;
**dadurch gekennzeichnet, dass** sie zusätzlich aufweist:
vier Zentrierführungen (207); und
einen Zentriermechanismus (200), der aufweist:
ein rotierendes Betätigungselement (203);
einen drehbaren Flansch (204);
für jede Zentrierführung (207) einen Gelenkarm (205), der die Zentrierführung (207) mit dem drehbaren Flansch (204) verbindet; und
für jede Zentrierführung (207) ein Befestigungsteil (209), das radial aus der Umfangsfläche (14) der Basis (13) vorsteht, und das einen Schlitz (206) aufweist, wobei die Zentrierführung (207) durch den Schlitz (206) hindurchgeht und durch den Schlitz (206) geführt wird, um so eine radiale Bewegung mit Bezugnahme auf die Mitte der Basis (13) als Reaktion auf die Drehung des drehbaren Flansches (204) mittels des rotierenden Betätigungselementes (203) durchzuführen.

2. Kontaktlose Transportvorrichtung (21) nach Anspruch 1, bei der der Zentriermechanismus (200) pneumatisch angetrieben wird.

3. Kontaktlose Transportvorrichtung (21) nach Anspruch 1, bei der die Stirnfläche (2b) einen abgefasten Rand (3a) aufweist.

## Revendications

1. Equipement de transport sans contact (21) pour transporter une plaquette de semi-conducteur, comprenant :
une base (13), comportant au moins deux corps (2), chaque corps (2) comportant une face d'extrémité (2b) opposée en service à une plaquette de semi-conducteur (9) devant être transportée, et au moins une ouverture concave (3) formée dans la face d'extrémité (2b) et entourée par une paroi latérale interne cylindrique ;
chaque corps (2) comportant un passage de fluide (5), comportant une paire d'orifices (4) pour introduire le fluide dans un espace interne de l'ouverture concave (3), le long d'une circonférence de la paroi latérale interne cylindrique, ledit fluide étant introduit en service dans ledit espace interne dans une direction horizontale par rapport à la face d'extrémité, de sorte à entraîner un tourbillon de fluide dans l'ouverture concave (3), la paire d'orifices (4) étant formée sur la paroi latérale interne cylindrique de sorte à se faire face ;
**caractérisé en ce qu'**il comprend en plus :
quatre guides de centrage (207) ; et
un mécanisme de centrage (200), comprenant :
un actionneur rotatif (203) ;
une bride rotative (204) ;
pour chaque guide de centrage (207), un bras de liaison (205) reliant le guide de centrage (207) à la bride rotative (204) ; et
pour chaque guide de centrage (207), une pièce de fixation (209), débordant radialement de la surface périphérique (14) de la base (13) et comportant une fente (206), le guide de centrage (207) traversant la fente (206) et étant guidé par la fente (206) de sorte à effectuer un déplacement radial par rapport au centre de la base (13), en réponse à la rotation de la bride rotative (204) par l'actionneur rotatif (203).

2. Equipement de transport sans contact (21) selon la revendication 1, dans lequel le mécanisme de centrage (200) est entraîné de manière pneumatique.

3. Equipement de transport sans contact (21) selon la revendication 1, dans lequel la face d'extrémité (2b) comprend un bord chanfreiné (3a).
